Europäisches Patentamt

European Patent Office

Office européen des brevets

(19)

(11) Publication number: **0 077 276**
A2

# (12) EUROPEAN PATENT APPLICATION

(21) Application number: **82401881.6**

(22) Date of filing: **13.10.82**

(51) Int. Cl.³: **H 01 L 49/02**

(30) Priority: **13.10.81 US 310030**

(43) Date of publication of application: **20.04.83**
Bulletin 83/16

(84) Designated Contracting States: **DE FR GB IT NL**

(71) Applicant: **FAIRCHILD CAMERA & INSTRUMENT CORPORATION, 464 Ellis Street, Mountain View California 94042 (US)**

(72) Inventor: **Roffey, Michael F., 5682 Keymar Drive, San Jose California 95123 (US)**

(74) Representative: **Chareyron, Lucien et al, Schlumberger Limited 42, rue Saint-Dominique, F-75340 Paris Cedex 07 (FR)**

(54) Method for fabricating a hybrid circuit module.

(57) A hybrid circuit module is fabricated by forming a housing around a lead frame such that a first portion of the lead frame is external to the housing and a second portion of the lead frame, which is thinner than the first portion, extends inwardly from the housing to provide interconnect means for attaching the lead frame to a hybrid circuit substrate mounted within the housing.

METHOD FOR FABRICATING A

HYBRID CIRCUIT MODULE

By

Michael F. Roffey

TECHNICAL FIELD

This invention relates to a method for fabricating a hybrid circuit module and particularly to a method for forming interconnects for such modules.

BACKGROUND

Because of its cost-effectiveness and its reliability as a circuit assembly technique, hybrid circuit technology has become widely utilized in mass markets such as automotive electronics. In addition, new developments in hybrid processing have allowed almost complete automation with an attendant drop in cost and rise in yield and reliability.

According to the conventional method for forming a hybrid circuit module, a thermoplastic outer housing is molded around the fingers of a prestamped lead frame of a particular thickness, typically about 0.030 inches, such that a portion of each of the lead frame fingers remains external to the housing to provide connector pins for connecting the circuit module to external circuitry while a second portion of each of the lead frame fingers extends inwardly from the housing to provide interconnects for attaching the lead frame to an internally mounted hybrid circuit substrate. The internal interconnects are attached to the substrate by welding them to thin tabs, typically about 0.005 inches thick, which previously have been reflow soldered to attach pads formed on the substrate. The thin tabs provide the flexibility needed to take up the stress caused by thermal expansion encountered in operation of the hybrid circuit.

DISCLOSURE OF THE INVENTION

According to the present invention, the need for the thin tabs common to prior art hybrid circuit modules is eliminated by providing a lead frame which comprises a first portion which is external to the module housing and a second portion integral with the first portion, which is internal to the module housing and which is thinner than the first portion.

According to the method of the present invention, this thinner internal portion of the lead frame, rather than being formed initially as a plurality of individual interconnect strips, is formed as a thin flat plate. Internal interconnect strips are then stamped from the plate by individual dies on-line at production just prior to attaching the lead frame to the hybrid circuit substrate. According to the preferred embodiment, the individual interconnect strips are bent to the appropriate location on the hybrid circuit substrate during the stamping process and spot soldered reflowed to the attach pads. The interconnect strips may be attached to the circuit substrate either prior to or subsequent to the formation of the module housing.

As stated above, the method of the present invention eliminates the need for separate thin attach tabs. In addition, the method of the present invention eliminates a sequence of welding operations and provides better piece part control and production line flexibility.

SUMMARY OF THE INVENTION

One aspect of the invention is directed to a method for fabricating a hybrid circuit module, comprising the steps of (a) placing a lead frame comprising a first portion and a second portion adjacent a hybrid circuit substrate, said second portion including a thin plate which is thinner than said first portion; (b) stamping said plate for form a plurality of interconnect strips therefrom; (c) attaching said interconnect strips to said hybrid circuit substrate; and (d) forming a housing around said lead frame and said substrate such that said first portion of said lead frame is external to said housing and said interconnect strips are internal to said housing.

Another aspect of the invention is directed to a hybrid circuit module comprising: (a) a hybrid circuit substrate; (b) a lead frame comprising a first portion and a second portion, said second portion being integral with said first portion and including interconnect means which is thinner than said first portion for attaching said lead frame to said substrate; and (c) a housing formed around said lead frame such that said first porton extends outwardly from said housing and said interconnnect means is internal to said housing.

BRIEF DESCRIPTION OF THE DRAWINGS

Fig. 1 is a cross-section view of a hybrid circuit module formed according to the technique of the prior art.

Fig. 2 is a plan view of a lead frame formed according to the method of the present invention.

Fig. 3 is a cross-section view of a hybrid module formed according to the method of the present invention.

Fig. 4 is a schematic illustration of a hybrid module having a lead frame plate which remains to be stamped to yield individual interconnect strips according to the method of the present invention.

Fig. 5 is a schematic illustration of a hybrid module having stamped interconnect strips which remain to be attached to attach pads on a hybrid circuit substrate according to the method of the present invention.

BEST MODE FOR PRACTICING THE INVENTION

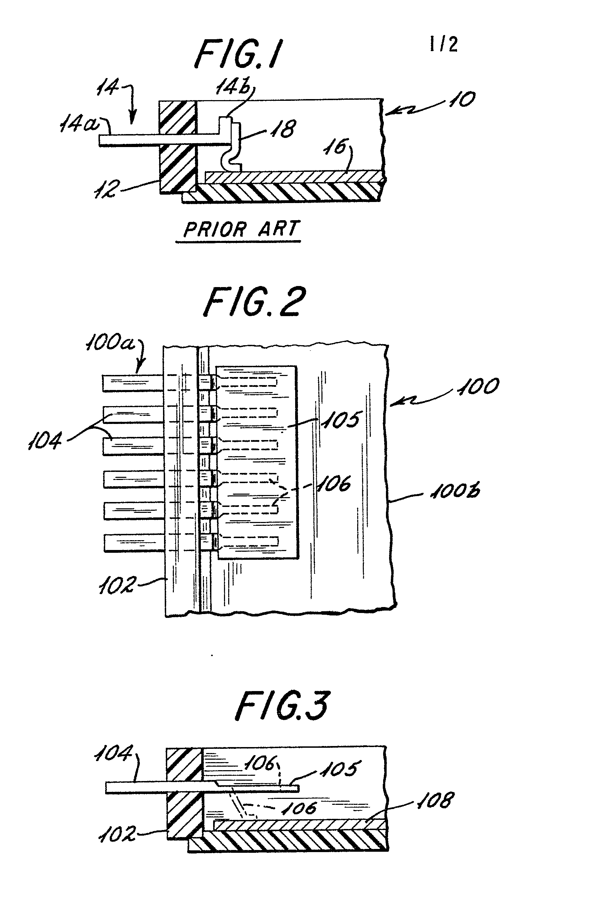

Fig. 1 shows a hybrid circuit module 10 which has been formed according to the prior art technique. A thermoplastic module housing 12 is formed around the fingers of a prestamped lead frame 14 of a particular uniform thickness, typically about 0.030 inches, such that a portion 14a of the lead frame 14 is external to the housing 12 to provide a plurality of connector pins for connecting the module to external circuitry. A second portion 14b of the lead frame 14 extends inwardly from the housing 12 to provide interconnects for attaching the lead frame 14 to an internally mounted hybrid circuit substrate 16.

The internal interconnects 14b are attached to the substrate 16 by welding the interconnects 14b to attach tabs 18 which are much thinner than the lead frame 14. Typically, the attach tabs 18 are about 0.005 inches thick. The attach tabs 18 are attached to the substrate 16 by reflow soldering the attach tabs 18 to attach pads (not shown) formed on the substrate 16.

According to the method of the present invention, the dual lead-frame/attach-tab structure shown in Fig. 1 is eliminated and replaced by a composite lead frame structure.

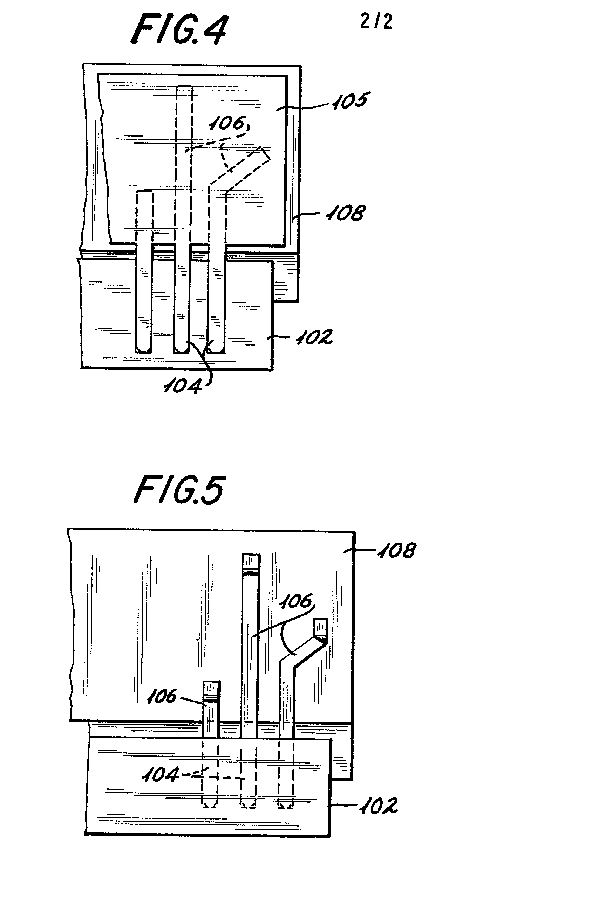

As shown in Figs. 2 and 3, according to the present invention, a lead frame 100 comprises a first portion 100a which is external to a thermoplastic hybrid circuit housing 102 and a second portion 100b which extends inwardly from the housing 102. The first portion 100a comprises a plurality of connector pins 104 which are of a first thickness, preferably the same thickness as that of the lead frame 10 of the prior art structure shown in Fig. 1. The second portion 100b includes a thin plate 105 which is thinner than the first portion 100a, and preferably is of a thickness comparable to that of the attach tabs 14 shown in Fig. 1. In a preferred embodiment, the lead frame 100 is tin-plated bronze.

According to one embodiment of the invention, the housing 102 is formed around the lead frame 100. Then the thin plate 105 is stamped according to conventional techniques to form a plurality of individual connector strips 106. These individual connector strips 106 are bent and spot reflow soldered to attach pads (not shown) formed on an underlying hybrid circuit substrate 108 as shown in Fig. 3. It is preferred that the connector strips 106 be bent during the stamping process. In the preferred embodiment, the substrate 108 is porcelain/steel.

According to an alternative embodiment, the individual connector strips 106 are stamped from the thin plate 105, bent and attached to the attach pads of the substrate 108 prior to formation of the module housing 102. The housing 102 is then formed around the lead frame 100 as discussed above as well as around the substrate 108.

Figs. 4 and 5 illustrate the formation of the individual interconnect strips 106, according to the method of the present invention. Fig. 4 shows a thin plate 105 which remains to be stamped to yield individual connector strips 106. Connector pins 104 extend through a housing 102 to interconnect strips 106 which have been stamped from the thin plate 105 to be attached to attach pads formed on the underlying circuit substrate 108. As may be seen with reference to Fig. 4, the method of the present invention provides the flexibility to change the stamping die to suit the location of the attach pads on the underlying substrate for differing layouts.

1. A method for fabricating a hybrid circuit module, characterized by the steps of:

(a) placing a lead frame comprising a first portion and a second portion adjacent a hybrid circuit substrate, said second portion including a thin plate which is thinner than said first portion;

(b) stamping said plate to form a plurality of interconnect strips therefrom;

(c) attaching said interconnect strips to said hybrid circuit substrate; and

(d) forming a housing around said lead frame and said substrate such that said first portion of said lead frame is external to said housing and said interconnect strips are internal to said housing.

2. A method as in claim 1 characterized in that said first portion comprises a plurality of connector pins.

3. A method as in claim 2 characterized in that said connector pins are about 0.030 inches thick and said interconnect strips are about 0.005 inches thick.

4. A method as in claim 1, 2 or 3 characterized in that said lead frame is tin-plated bronze.

5. A method as in any one of claims 1 to 4 characterized in that step (d) is performed between steps (a) and (b).

6. A method as in any one of claims 1 to 4 characterized in that step (d) is performed after step (c).

7. A hybrid circuit module comprising:

(a) a hybrid circuit substrate; characterized by

(b) a lead frame comprising a first portion and a second portion, said second portion being integral with said first portion and including interconnect means which is thinner than said first portion for attaching said lead frame to said substrate; and

(c) a housing formed around said lead frame such that said first porton extends outwardly from said housing and said interconnnect means is internal to said housing.

8. A hybrid circuit module according to claim 7 characterized in that said interconnect means comprises a plurality of interconnect strips.

9. A hybrid circuit module according to claim 7 or 8 characterized in that said first portion comprises a plurality of connector pins.

10. A hybrid circuit module according to claim 8 and 9 characterized in that said interconnect strips are about 0.005 inches thick and said connector pins are about 0.030 inches thick.

11. A hybrid circuit module according to any one of claims 7 to 10 characterized in that said lead frame is tin-plated bronze.

12. A hybrid circuit module according to any one of claims 7 to 11 characterized in that said substrate is porcelain/steel.

0077276

FIG.1

1/2

PRIOR ART

FIG.2

FIG.3

**FIG.4**

**FIG.5**